# EUROPEAN PATENT SPECIFICATION

(11) **EP 2 978 294 B1**
(45) Date of publication and mention of the grant of the patent: **03.01.2018**
(21) Application number: 13878953.2
(22) Date of filing: 19.03.2013
(51) Int. Cl.: H05K 13/02, H05K 13/04, H05K 13/08

(54) **COMPONENT MOUNTING MACHINE**
MASCHINE ZUR MONTAGE VON KOMPONENTEN
MACHINE DE MONTAGE DE COMPOSANT

(43) Date of publication of application: 27.01.2016
(73) Proprietor: Fuji Machine Mfg. Co., Ltd., Chiryu-shi, Aichi 472-8686 (JP)
(72) Inventor: KANDA Tomohisa, Chiryu-shi Aichi 472-8686 (JP); IDO Takehiro, Chiryu-shi Aichi 472-8686 (JP); KASAI Takahiro, Chiryu-shi Aichi 472-8686 (JP); YOSHINO Tomoharu, Chiryu-shi Aichi 472-8686 (JP)
(74) Representative: Grünecker Patent- und Rechtsanwälte PartG mbB
(86) International application number: PCT/JP2013/057762
(87) International publication number: WO 2014/147733

(56) References cited:
- JP-A- 2005 277 212
- JP-A- 2010 109 109
- JP-A- 2011 082 438
- JP-A- 2012 114 182

## Description

### Technical Field

The present invention relates to a component mounting machine which picks up a component from a component packing tape with a top tape adhered to the upper surface side of a carrier tape in which the component is stored, and transfers and mounts the component on a printed circuit board, and in particular, relates to a component mounting machine which is able to remove dust which is generated when the top tape is peeled off from the carrier tape in a tape peeling section of a tape feeder which supplies the component packing tape.

### Background Art

For example, in the related art, PTL 1 discloses a component mounting machine that is provided with a suction fan, which suctions air that contains dust that is generated in a tape peeling section of a tape feeder, inside a tape collection duct (tape discharge duct) which collects carrier tape after component pickup. According to this component mounting machine, air that contains dust is suctioned inside the tape collection duct from an inlet of the tape collection duct, dust is separated using a filter belonging to the suction fan, and is then discharged outside from an outlet of the tape collection duct.

### Citation List

### Patent Literature

[PTL 1]JP-A-2011-82438

### Summary of Invention

### Technical Problem

Since a tape collection duct of the component mounting machine described above is provided further to the back side of a mounting machine body than the tape peeling section of the tape feeder, there are cases where a portion of air that contains dust flows to the back side of the mounting machine body without being suctioned inside the tape collection duct. In this case, there is a concern that a component mounting defect is generated when dust which is contained in air that flows to the back side of the mounting machine body adheres to a lens of a component recognition camera, on the printed circuit board, or the like.

The present invention is carried out in consideration of the above circumstances, and an object thereof is to provide a component mounting machine which is able to prevent air that contains dust flowing further to the back side of a mounting machine body than a tape peeling section of a tape feeder.

### Solution to Problem

In order to solve the problem, according to the invention of Claim 1, there is provided a component mounting machine, which picks up a component from a component packing tape with a top tape adhered to the upper surface side of a carrier tape in which the component is stored, and transfers and mounts the component on a printed circuit board, including a component supply device to which a tape feeder which conveys the component packing tape to a tape peeling section, separates the top tape from the carrier tape, and conveys the carrier tape to the component supply position is detachably mounted; a component transfer device which picks up and transfers the component that is stored in the carrier tape at the component supply position, and mounts the component on the printed circuit board which is positioned at the component mounting position that is positioned further to the back side of a mounting machine body than the component supply position; and a blower which blows air from a position further to the back side of the mounting machine body than the component supply position and further to the front side of the mounting machine body than the component mounting position toward the tape peeling section.

Thereby, since the air which is blown from the blower flows from the back side of the mounting machine body toward the front side of the mounting machine body through a tape peeling section of a tape feeder, it is possible to prevent dust, which is particularly generated in the tape peeling section, from adhering to a lens of a component imaging camera for imaging a component, a printed circuit board, or the like. Thereby, it is possible to increase recognition precision of the component, and it is also possible to prevent manufacturing defects such as contact defaults of the component on the printed circuit board.

According to the invention of Claim 2, in Claim 1, the component mounting machine further includes a tape collection duct for collecting the carrier tape from which the stored component has been picked up and which is provided further to the back side of the mounting machine body than the component supply position, in which the blower is provided at a lower position than the transfer height of the component on the tape collection duct. Thereby, when the component which is supplied by the component supply device and picked up by the component transfer device is transferred on the printed circuit machine body than the component supply position toward the tape peeling section.

Thereby, since the air which is blown from the blower flows from the back side of the mounting machine body toward the front side of the mounting machine body through a tape peeling section of a tape feeder, it is possible to prevent dust, which is particularly generated in the tape peeling section, from adhering to a lens of a component imaging camera for imaging a component, a printed circuit board, or the like. Thereby, it is possible to increase recognition precision of the component, and it is also possible to prevent manufacturing defects such as contact defaults of the component on the printed circuit board.

According to the invention of Claim 2, in Claim 1, the component mounting machine further includes a tape collection duct for collecting the carrier tape from which the stored component has been picked up and which is provided further to the back side of the mounting machine body than the component supply position, in which the blower is provided at a lower position than the transfer height of the component on the tape collection duct. Thereby, when the component which is supplied by the component supply device and picked up by the component transfer device is transferred on the printed circuit board, there is no concern that the component and the blower interfere, and it is possible to take precautions against generation of mounting defects.

According to the invention of Claim 3, in Claim 1 or 2, the blower is provided with a tubular member in which a plurality of holes are bored at predetermined intervals, so as to blow air toward the tape peeling section. Thereby, it is possible to effectively blow air from each hole of the blower with respect to the tape peeling section of each tape feeder by the plurality of holes of the blower being bored at an interval corresponding to the pitch at which the tape feeders which are aligned side by side.

According to the invention of Claim 4, in any one of Claims 1 to 3, the component mounting machine further includes an upward suction and exhaust device which is provided in an upper section further to the front side of the mounting machine body than the tape peeling section, and suctions and exhausts air which is blown from the blower toward the tape peeling section such that the air flows to an upper part of the mounting machine body. Thereby, since the air which is blown from the blower toward the tape peeling section is suctioned and exhausted by the upward suction and exhaust device, it is possible to generate airflow flowing from the back side of the mounting machine body upward facing the front side, and prevent reverse flow of the air to the back side of the mounting machine body.

According to the invention of Claim 5, in Claim 4, the upward suction and exhaust device includes a filter which traps dust contained in suctioned air. Thereby, since dust which is contained in the air that is suctioned to the upward suction and exhaust device is trapped by the filter, and the air which is exhausted from the upward suction and exhaust device is cleaned, it is possible to prevent dispersion of the dust by the air being moved to an upper part of the mounting machine body.

According to the invention of Claim 6, in Claim 4 or 5 , the component mounting machine further includes a suction and exhaust device for discharge which is provided further to the upper section at the back side of the mounting machine body than the upward suction and exhaust device, and suctions and exhausts air which is discharged from the upward suction and exhaust device such that the air is discharged to the outside of the mounting machine body.

Thereby, since the air which is discharged from the upward suction and exhaust device is suctioned and exhausted to the suction and exhaust device for discharge, it is possible to move air from the front side toward the back side at an upper part of the mounting machine body, further generate airflow which flows toward the outside of the mounting machine body, discharge air around the tape feeder that rises due to heat generated by driving the tape feeder to outside the mounting machine body, and suppress rising of the atmospheric temperature around the tape feeder.

### Brief Description of Drawings

[Fig. 1] Fig. 1 is a perspective view illustrating a component mounting machine according to an embodiment of the present invention.
[Fig. 2] Fig. 2 is a side surface view illustrating a schematic configuration of the component mounting machine of Fig. 1.
[Fig. 3] Fig. 3 is a perspective view illustrating a component packing tape which is used by the component mounting machine of Fig. 1.
[Fig. 4] Fig. 4 is a perspective view illustrating details of a blower of the component mounting machine of Fig. 1.
[Fig. 5] Fig. 5 is a view illustrating a disposition and airflow of the blower of the component mounting machine of Fig. 1.

### Description of Embodiments

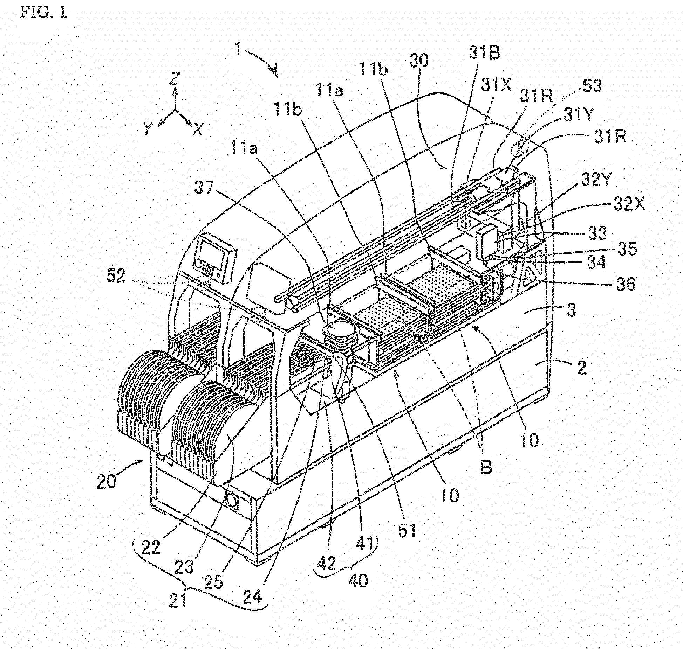

An embodiment of a component mounting machine according to the present invention will be described below. Here, in Fig. 1 a state is indicated in which two component mounting machines 1 are mounted in a line on one stand 2, but there are also cases where only one component mounting machine 1 is configured in a component mounting line, or a plurality of component mounting machines 1 are disposed side by side. In the description below, a direction in which the two component mounting machines 1 line up, that is, the conveyance direction of a printed circuit board B is referred to as the X axis direction, a direction which is perpendicular to the X axis direction inside a horizontal plane is referred to as the Y axis direction, and a direction which is perpendicular to the X axis direction and the Y axis direction is referred to as the Z axis direction.

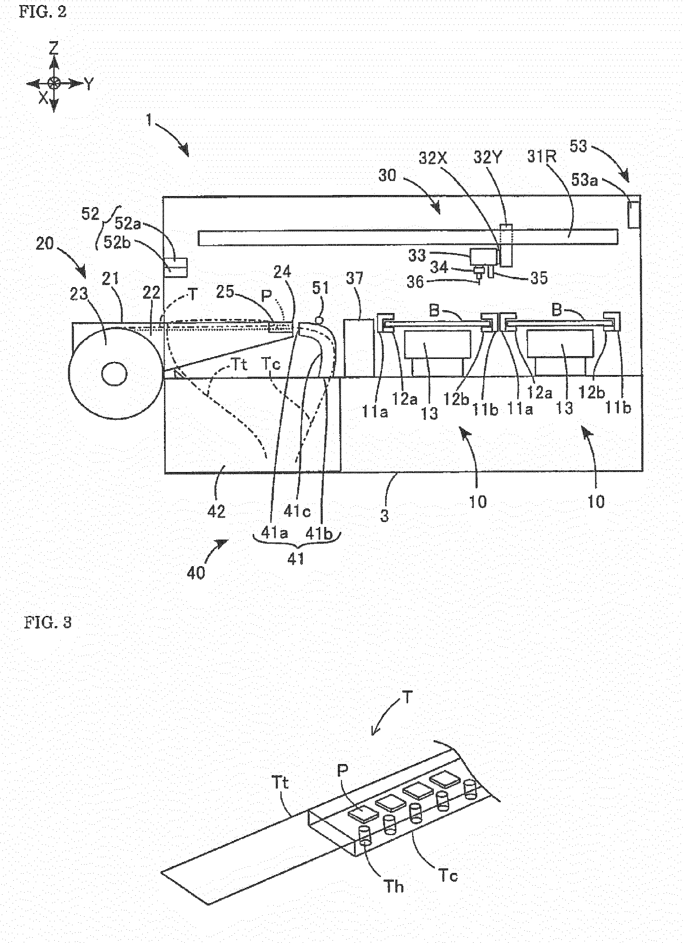

As shown in Figs. 1 and 2, the component mounting machine 1 is configured so as to be provided with a board conveyance device 10 which is provided at the back side (the right side in Figs. 1 and 2) of a mounting machine body 3 and conveys the printed circuit board B, a component supply device 20 which is provided at the front surface side (the left side in Figs. 1 and 2) of the mounting machine body 3 and supplies a component P (refer to Fig. 3) which is mounted on the printed circuit board B, a board conveyance device 30 which is provided above both devices 10 and 20, picks up and transfers the component P that is supplied by the component supply device 20, and mounts the component P on the printed circuit board B which is conveyed by the board conveyance device 10, a tape collection device 40 which is provided further to the back side of the mounting machine body 3 than a component supply section 24 of a tape feeder 21 of the component supply device 20 and collects a component packing tape T (refer to Fig. 3) after the component P is picked up, and the like.

Furthermore, the component mounting machine 1 is configured so as to be provided with a blower 51 which is disposed on the tape collection device 40 and blows air from further to the back side of the mounting machine body 3 than the component supply section 24 of the tape feeder 21 toward a tape peeling section 25, an upward suction and exhaust device 52 that is provided further on an upper section to the front side of the mounting machine body 3 than the tape peeling section 25 of the component supply device 20 and suctions and exhausts air which is blown from the blower 51 toward the tape peeling section 25 such that the air flows to an upper part of the mounting machine body 3, a suction and exhaust device for discharge 53 that is provided further on the upper section to the back side of the mounting machine body 3 than the upward suction and exhaust device 52 and suctions and exhausts air which is exhausted from the upward suction and exhaust device 52 such that the air is discharged outside of the mounting machine body 3, and the like.

The board conveyance device 10 is a device of a so-called double conveyor type which is able to convey the printed circuit boards B in two rows one by one. The board conveyance device 10 is provided with two each of a pair of guide rails 11a and 11b, a pair of conveyor belts 12a and 12b, a clamp device 13, and the like. The pair of guide rails 11a and 11b extend in the Y direction and are disposed in parallel to each other at substantially the same distance as the width of the printed circuit board B. The pair of conveyor belts 12a and 12b are parallel directly under the guide rails 11a and 11b. The clamp device 13 is disposed below a component mounting position (a position of the printed circuit board B which is illustrated by a dotted line in Fig. 1) between the pair of guide rails 11a and 11b.

In the board conveyance device 10, the printed circuit board B is conveyed to the component mounting position by the pair of conveyor belts 12a and 12b while being guided in the Y direction by the pair of guide rails 11a and 11b, the printed circuit board B is positionally fixed using a clamp by being pushed up from the conveyor belts 12a and 12b using the clamp device 13.

The component supply device 20 is a device of a cassette type which is configured to be parallel to a plurality of the tape feeder 21 in the Y direction at the front surface side of the mounting machine body 3. The tape feeder 21 is provided with a feeder body 22 which is detachably mounted to the mounting machine body 3, a supply reel 23 detachably mounted to the rear section of the feeder body 22, the component supply section 24 which is provided at the component supply position on the distal end of the feeder body 22, the tape peeling section 25 which is provided further to the front than the component supply section 24, and the like.

The component packing tape T is held so as to be wound on the supply reel 23. As shown in Fig. 3, the component packing tape T is provided with a carrier tape Tc which stores the component P at a predetermined pitch, and a top tape Tt which covers the component P by being adhered to the upper surface of the carrier tape Tc. A sprocket hole Th is bored at a certain pitch in one side edge section of the component packing tape T.

In the component supply device 20, teeth of a sprocket, which is not shown, are engaged in order to the sprocket hole Th by rotating the sprocket which is provided in the tape feeder 21, and the component packing tape T is pulled out from the supply reel 23 at a predetermined pitch. Then, the top tape Tt is peeled off from the carrier tape Tc in the tape peeling section 25, and the components P in which a sealed state is released are sequentially fed to the component supply section 24. The top tape Tt which is peeled off is conveyed behind the feeder body 22, is fed to a tape storage box 42 of the tape collection device 40, and after the components P are picked up, the carrier tape Tc is conveyed in front of the feeder body 22, and fed to the tape storage box 42 through a tape collection duct 41 of the tape collection device 40.

The component transfer device 30 is a device of an XY robot type which is disposed above the board conveyance device 10 and the component supply device 20 by being mounted on an upper section of the mounting machine body 3. The component transfer device 30 is provided with a Y-axis slider 32Y which moves in the Y axis direction along a rail 31R by means of a Y-axis servo motor 31Y via a ball screw 31B, an X-axis slider 32X which moves in the X axis direction by means of an X-axis servo motor 31X via a ball screw, which is not shown, and the like. The X-axis slider 32X is guided to the Y-axis slider 32Y so as to be movable in the X axis direction. A component mounting head 33, which mounts the component P on the printed circuit board B, is attached to the X-axis slider 32X.

A nozzle holder section 34 that has a component suction nozzle 36, which is provided so as to protrude downward and sucks and holds the component P, on a lower end section, and a board imaging camera 35 which images the printed circuit board B that is positionally fixed at a component mounting position are attached to the component mounting head 33. The nozzle holder section 34 is supported on the component mounting head 33 so as to be liftable in the Z axis direction using the servo motor, which is not shown, and is able to rotate about the Z axis. The component suction nozzle 36 is connected to a vacuum pump, which is not shown, such that the component is able to be sucked at the nozzle distal end. In addition, a component imaging camera 37, which images the component P that is sucked and held to the component suction nozzle 36, is provided between the board conveyance device 10 and the component supply device 20.

In the component transfer device 30, the component P, which is supplied to the component supply section 24 (component supply position) by the component supply device 20, is sucked and held to the component suction nozzle 36, is moved above the component imaging camera 37 by the Y-axis slider 32Y and the X-axis slider 32X, and the posture of the component is corrected by recognizing an image which is imaged by the component imaging camera 37. Then, the component is moved by the Y-axis slider 32Y and the X-axis slider 32X above a printed circuit board P which is conveyance positioned to a component mounting position that is positioned further to the back side of the mounting machine body 3 than component supply position by the board conveyance device 10, and is mounted at a predetermined mounting position on the printed circuit board P.

The tape collection device 40 is provided with the tape collection duct 41 which collects the carrier tape Tc, the tape storage box 42 which is disposed below the tape collection duct 41 and stores the carrier tape Tc that is introduced to the top tape Tt, which is peeled off from the carrier tape Tc, and the tape collection duct 41, and the like.

A tape inlet 41a with a rectangular form which is open toward the component supply section 24 of the plurality of tape feeders 21 which are parallel in the Y direction, and a tape discharge outlet 41b with a rectangular form which is connected to the upper surface of the tape storage box 42, are formed in the tape collection duct 41. Then, the tape collection duct 41 is provided with a duct body 41c which is curved so as to be convex toward the back side of the mounting machine body 3 from the tape inlet 41a to the tape discharge outlet 41b. Since the duct body 41c is curved so as to be convex toward the back side of the mounting machine body 3, it is possible to smoothly guide the carrier tape Tc, which is fed out from the component supply section 24 of the tape feeder 21 and from which the component P has been sucked out, toward the tape storage box 42.

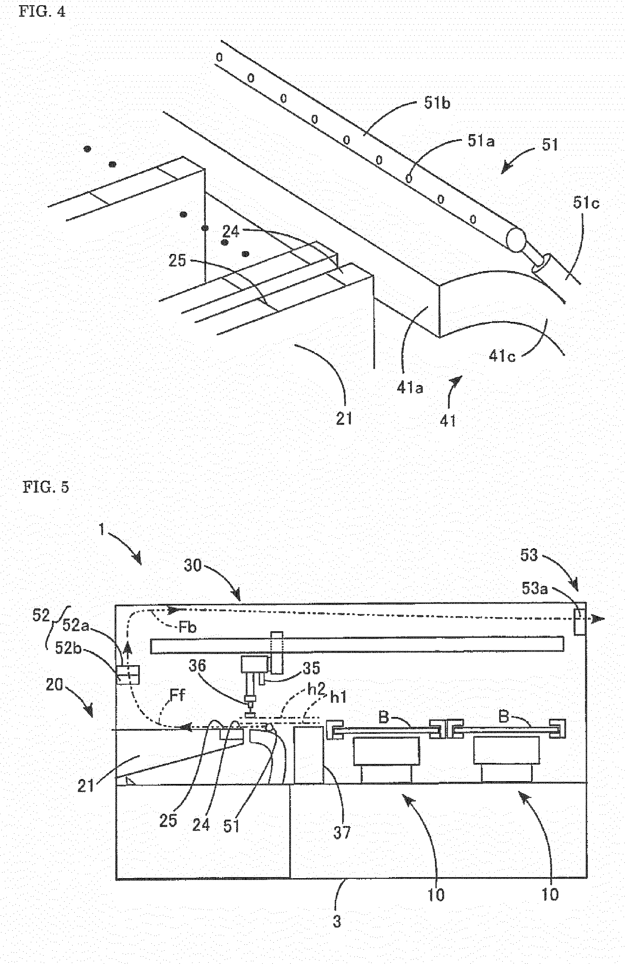

As shown in Fig. 4, the blower 51 is provided with a tubular member 51b into which a plurality of holes 51a are bored at predetermined intervals, a pipe 51c for connecting the tubular member 51b and an air supply source, which is not shown, and the like. The plurality of holes 51a of the tubular member 51b are, for example, bored at an interval corresponding to the pitch of the tape feeders 21 which are parallel in the Y direction. The tubular member 51b is blocked at one end side, the other end side is connected to the pipe 51c, and is fixedly disposed so as to extend in the Y direction toward the tape peeling section 25 of each tape feeder 21 in which each hole 51a is aligned side by side in the vicinity of the tape inlet 41a on the duct body 41c of the tape collection duct 41. Thereby, it is possible to effectively blow air from each hole 51a of the blower 51 with respect to the tape peeling section 25 of each tape feeder 21.

By providing the blower 51, since the air which is blown from each hole 51a of the tubular member 51b through the pipe 51c flows from the back side of the mounting machine body 3 toward the front side of the mounting machine body 3 through the tape peeling section 25 of each tape feeder 21, it is possible to prevent dust which is particularly generated in the tape peeling section 25 from adhering to a lens of a component imaging camera 35, a printed circuit board P, or the like. Thereby, it is possible to increase recognition precision of the component P, and it is also possible to prevent manufacturing defects such as contact defaults of the component P on the printed circuit board B.

In addition, the tubular member 51b is provided so as to be positioned lower than the transfer height of the component P which is transferred by being sucked to the component suction nozzle 36. That is, as shown in Fig. 5, the tubular member 51b is provided on the duct body 41c such that a height h1 of an upper section of the tubular member 51b is lower than a transfer height h2 of the component P. Thereby, when the component P is transferred on the printed circuit board B, there is no concern that the component P and a tubular member 43b interfere, and it is possible to take precautions against generation of mounting defects.

As shown in Fig. 2, the upward suction and exhaust device 52 is provided with an electric fan 52a which is attached to the center of a front surface upper section of the mounting machine body 3 and is able to suction and exhaust from below to above, a filter 52b which traps dust which is contained in the suctioned air, and the like. As shown in Fig. 5, since the air which is blown from the blower 51 toward the tape peeling section 25 is suctioned and exhausted to the electric fan 52a in the upward suction and exhaust device 52, by providing the upward suction and exhaust device 52, it is possible to generate airflow Ff which flows from the back side of the mounting machine body 3 upward facing the front side, and prevent reverse flow of the air to the back side of the mounting machine body 3. Then, since dust, which is contained in the air that is suctioned in the electric fan 52a, is trapped by the filter 52b, and the air which is exhausted from the electric fan 52a is cleaned, it is possible to prevent dispersion of the dust by the air being moved to an upper part of the mounting machine body 3.

As shown in Fig. 2, the suction and exhaust device for discharge 53 is attached to the upper section further to the back side of the mounting machine body 3 than the upward suction and exhaust device 52, the center at the back surface upper section of the mounting machine body 3 in the present example, and is provided with an electric fan 53a which is able to discharge air from the inside of the mounting machine body 3 toward the outside of the mounting machine body 3 , and the like. As shown in Fig. 5, since the air which is discharged from the upward suction and exhaust device 52 is suctioned and exhausted to the electric fan 53a of the suction and exhaust device for discharge 53, by providing the suction and exhaust device for discharge 53, airflow Fb is generated flowing from the front side to the back side at an upper part of the mounting machine body 3 , and further, toward the outside of the mounting machine body 3. Consequently, in the related art, the atmospheric temperature around the tape feeder 21 is raised due to heat generated by a driving motor of the tape feeder 21, but since the air in which the temperature is raised due to the airflow is discharged to the outside of the mounting machine body 3, it is possible to control the raising of atmospheric temperature around the tape feeder 21.

Here, in the embodiment described above, there is a configuration in which the blower 51 is provided which blows to the front surface side of the mounting machine body 3 with respect to the plurality of tape feeders 21 of the component supply device 20 that is provided at the front surface side of the mounting machine body 3, but there may be a configuration in which the component supply device 20 is provided on each of the front surface side and the back surface side of the mounting machine body 3, and the blower 51 which blows to the front surface side of the mounting machine body 3 and the blower 51 which blows to the back surface side of the mounting machine body 3 are each provided with respect to the plurality of tape feeders 21 of each component mounting device 20. In this case, the suction and exhaust device for discharge 53 may be provided on the ceiling, and air may be discharged upward to outside the mounting machine body 3. Here, even in the embodiment described above, the suction and exhaust device for discharge 53 may be provided on the ceiling, and air may be discharged upward to outside the mounting machine body 3.

### Industrial Applicability

The present invention is able to be applied to a component mounting machine which supplies a component using a component packing tape, a tray, and the like.

### Reference Signs List

1: COMPONENT MOUNTING MACHINE, 10: BOARD CONVEYANCE DEVICE, 20: COMPONENT SUPPLY DEVICE, 30: COMPONENT TRANSFER DEVICE, 40: TAPE collection DEVICE, 41: TAPE collection DUCT, 42: TAPE STORAGE BOX, 51: BLOWER, 51a: HOLE, 51b: TUBULAR MEMBER, 51c: PIPE, 52: UPWARD SUCTION AND EXHAUST DEVICE, 52a: FAN, 52b: FILTER, 53: SUCTION AND EXHAUST DEVICE FOR DISCHARGE, 53a: FAN, T: COMPONENT PACKING TAPE, Tt: TOP TAPE, Tc: CARRIER TAPE

## Claims

1. A component mounting machine (1), which picks up a component (P) from a component packing tape (T) with a top tape (Tt) adhered to the upper surface side of a carrier tape (Tc) in which the component (P) is stored, and transfers and mounts the component (P) on a printed circuit board (B), comprising:
a component supply device (20) to which a tape feeder (21) which conveys the component packing tape (T) to a tape peeling section (25), separates the top tape (Tt) from the carrier tape (Tc), and conveys the carrier tape (Tc) to the component supply position (24) is detachably mounted;
a component transfer device (30) which picks up and transfers the component (P) that is stored in the carrier tape (Tc) at the component supply position (24), and mounts the component (P) on the printed circuit board (B) which is positioned at the component mounting position that is positioned further to the back side of a mounting machine body (3) than the component supply position (24);
wherein the component mounting machine (1) is **characterized by,**
a blower (51) which blows air from a position further to the back side of the mounting machine body (3) than the component supply position (24) and further to the front side of the mounting machine body (3) than the component mounting position toward the tape peeling section (25).

2. The component mounting machine (1) according to Claim 1, further comprising:
a tape collection duct (41) for collecting the carrier tape (Tc) from which the stored component (P) has been picked up and which is provided further to the back side of the mounting machine body (3) than the component supply position (24),
wherein the blower (51) is provided at a lower position than the transfer height of the component (P) on the tape collection duct (41).

3. The component mounting machine (1) according to Claim 1 or 2,
wherein the blower (51) is provided with a tubular member (51b) in which a plurality of holes (51a) are bored at predetermined intervals, so as to blow air toward the tape peeling section (25).

4. The component mounting machine (1) according to any one of Claims 1 to 3, further comprising:
an upward suction and exhaust device (52) which is provided in an upper section further to the front side of the mounting machine body (3) than the tape peeling section (25), and suctions and exhausts air which is blown from the blower (51) toward the tape peeling section (25) such that the air flows to an upper part of the mounting machine body (3).

5. The component mounting machine (1) according to Claim 4,
wherein the upward suction and exhaust device (52) includes a filter (52b) which traps dust contained in suctioned air.

6. The component mounting machine (1) according to Claim 4 or 5, further comprising:
a suction and exhaust device for discharge (53) which is provided further to the upper section at the back side of the mounting machine body (3) than the upward suction and exhaust device (52), and suctions and exhausts air which is discharged from the upward suction and exhaust device (52) such that the air is discharged to the outside of the mounting machine body (3).

## Patentansprüche

1. Bauelement-Montagemaschine (1), die ein Bauelement (P) von einem Bauelement-Verpackungsband (T) aufnimmt, bei dem ein Abdeckband (Tt) an der Seite einer oberen Fläche eines Trägerbandes (Tc) angeklebt ist, in dem das Bauelement (P) aufbewahrt wird, und die das Bauelement (P) zu einer Leiterplatte (B) überführt und daran montiert, wobei sie umfasst:
eine Bauelement-Zuführvorrichtung (20), an der eine Band-Vorschubeinrichtung (21) abnehmbar angebracht ist die, das Bauelement-Verpackungsband (T) zu einem Bandabzieh-Teilabschnitt (25) transportiert, das Abdeckband (Tt) von dem Trägerband (Tc) trennt und das Trägerband (Tc) zu der Bauelement-Zuführposition (24) transportiert;
eine Bauelement-Überführungsvorrichtung (30), die das Bauelement (P), das in dem Trägerband (Tc) aufbewahrt wird, aufnimmt und an der Bauelement-Zuführposition (24) überführt und das Bauelement (P) an der Leiterplatte (B) montiert, die sich an der Bauelement-Montageposition befindet, die sich näher an der hinteren Seite eines Körpers (3) der Montagemaschine befindet als die Bauelement-Zuführposition (24);
wobei die Bauelement-Montagemaschine (1) **gekennzeichnet ist durch**:
ein Gebläse (51), das Luft von einer Position, die näher an der hinteren Seite des Körpers (3) der Montagemaschine liegt als die Bauelement-Zuführposition (24) und näher an der vorderen Seite des Körpers (3) der Montagemaschine liegt als die Bauteil-Montageposition, auf den Bandabzieh-Teilabschnitt (25) zu bläst.

2. Bauelement-Montagemaschine (1) nach Anspruch 1, die des Weiteren umfasst:
eine Bandsammel-Leitung (41) zum Sammeln des Trägerbandes (Tc), aus dem das aufbewahrte Bauelement (P) aufgenommen worden ist, die näher an der hinteren Seite des Körpers (3) der Montagemaschine liegt als die Bauelement-Zuführposition (24),
wobei sich das Gebläse (51) an der Bandsammel-Leitung (41) an einer Position befindet, die tiefer liegt als die Höhe, in der das Bauelement (P) überführt wird.

3. Bauelement-Montagemaschine (1) nach Anspruch 1 oder 2,
wobei das Gebläse (51) mit einem röhrenförmigen Element (51b) versehen ist, in das eine Vielzahl von Löchern (51a) in vorgegebenen Abständen gebohrt sind, um die Luft auf den Bandabzieh-Teilabschnitt (25) zu blasen.

4. Bauelement-Montagemaschine (1) nach einem der Ansprüche 1 bis 3, die des Weiteren umfasst:
eine oben angeordnete Ansaug-und-Ausstoß-Vorrichtung (52), die sich an einem oberen Teilabschnitt befindet, der näher an der vorderen Seite des Körpers (3) der Montagemaschine liegt als der Bandabzieh-Teilabschnitt (25), und die Luft ansaugt und ausstößt, die von dem Gebläse (51) auf den Bandabzieh-Teilabschnitt (25) zu geblasen wird, so dass die Luft zu einem oberen Teil des Körpers (3) der Montagemaschine strömt.

5. Bauelement-Montagemaschine (1) nach Anspruch 4,
wobei die oben angeordnete Ansaug-und-Ausstoß-Vorrichtung (52) einen Filter (52b) enthält, der in angesaugter Luft enthaltenen Staub einfängt.

6. Bauelement-Montagemaschine (1) nach Anspruch 4 oder 5, die des Weiteren umfasst:
eine Ansaug-und-Ausstoß-Vorrichtung (53) zur Ableitung, die sich an der hinteren Seite des Körpers (3) der Montagemaschine näher an dem oberen Teilabschnitt befindet als die oben angeordnete Ansaug-und-Ausstoß-Vorrichtung (52) und die Luft ansaugt und ausstößt, die von der oben angeordneten Ansaug-und-Ausstoß-Vorrichtung (52) abgeleitet wird, so dass die Luft von dem Körper (3) der Montagemaschine nach außen abgeleitet wird.

## Revendications

1. Machine de montage de composants (1) qui prélève un composant (P) d'une bande de boîtiers de composants (T) comportant une bande supérieure (Tt) collée du côté de la surface supérieure d'une bande porteuse (Tc) dans laquelle est stocké le composant (P), et qui transfère et monte le composant (P) sur une carte à circuit imprimé (B), comprenant :
un dispositif d'alimentation en composants (20) sur lequel est monté tout en étant démontable un dispositif d'alimentation de bande (21) qui transporte la bande de boîtiers de composants (T) vers une section de décollement de bande (25), sépare la bande supérieure (Tt) de la bande porteuse (Tc) et transporte la bande porteuse (Tc) vers la position de délivrance de composant (24),
un dispositif de transfert de composants (30) qui prélève et transfère le composant (P) qui est stocké dans la bande porteuse (Tc) au niveau de la position de délivrance de composant (24) et monte le composant (P) sur la carte à circuit imprimé (B) qui est positionnée au niveau de la position de montage de composant elle-même placée plus loin vers l'arrière d'un corps de machine de montage (3) que la position de délivrance de composant (24),
dans lequel la machine de montage de composants (1) est **caractérisée par** :
un dispositif de ventilation (51) qui souffle de l'air depuis une position située plus loin vers l'arrière du corps de machine de montage (3) que la position de délivrance de composant (24) et plus loin vers l'avant du corps de machine de montage (3) que la position de montage de composant vers la section de décollement de bande (25).

2. Machine de montage de composants (1) selon la revendication 1, comprenant en outre :
un conduit de recueil de bande (41) destiné à recueillir la bande porteuse (Tc) à partir de laquelle le composant (P) stocké a été prélevé et qui est prévu plus loin vers l'arrière du corps de machine de montage (3) que la position de délivrance de composant (24),
dans laquelle le dispositif de ventilation (51) est prévu à une position plus basse que la hauteur de transfert du composant (P) sur le conduit de recueil de bande (41).

3. Machine de montage de composants (1) selon la revendication 1 ou la revendication 2,
dans laquelle le dispositif de ventilation (51) est doté d'un élément tubulaire (51b) dans lequel une pluralité de trous (51a) sont percés à des intervalles prédéterminés de sorte à souffler l'air vers la section de décollement de bande (25).

4. Machine de montage de composants (1) selon l'une quelconque des revendications 1 à 3, comprenant en outre :
un dispositif d'aspiration vers le haut et d'évacuation (52) qui est prévu dans une section supérieure plus loin vers l'avant du corps de machine de montage (3) que la section de décollement de bande (25), et qui aspire et évacue l'air soufflé du dispositif de ventilation (51) vers la section de décollement de bande (25) de sorte à ce que l'air s'écoule vers la partie supérieure du corps de machine de montage (3).

5. Machine de montage de composants (1) selon la revendication 4,
dans laquelle le dispositif d'aspiration vers le haut et d'évacuation (52) inclut un filtre (52b) qui piège la poussière contenue dans l'air aspiré.

6. Machine de montage de composants (1) selon la revendication 4 ou la revendication 5, comprenant en outre :
un dispositif d'aspiration et d'évacuation pour refoulement (53) qui est prévu plus loin vers la section supérieure au niveau de l'arrière du corps de machine de montage (3) que le dispositif d'aspiration vers le haut et d'évacuation (52) et qui aspire l'air qui est déchargé du dispositif d'aspiration vers le haut et d'évacuation (52) de sorte à ce que l'air soit refoulé vers l'extérieur du corps de machine de montage (3).
